# EUROPÄISCHE PATENTSCHRIFT

(11) **EP 3 062 359 B1**
(45) Veröffentlichungstag und Bekanntmachung des Hinweises auf die Patenterteilung: **16.08.2017**
(21) Anmeldenummer: 16156885.2
(22) Anmeldetag: 23.02.2016
(51) Int. Cl.: H01L 39/24, H01B 12/10

(54) **HALBZEUGDRAHT FÜR EINEN NB3SN-SUPRALEITERDRAHT UND VERFAHREN ZUR HERSTELLUNG DES HALBZEUGDRAHTS**
PRECURSOR WIRE FOR A NB3SN SUPERCONDUCTING WIRE AND METHOD FOR PRODUCING THE PRECURSOR WIRE
FIL PRECURSEUR POUR UN FIL SUPRACONDUCTEUR NB3SN ET PROCEDE DE FABRICATION DU FIL PRECURSEUR

(30) Priorität: 24.02.2015 DE 102015203305
(43) Veröffentlichungstag der Anmeldung: 31.08.2016
(73) Patentinhaber: Bruker EAS GmbH, 63450 Hanau (DE)
(72) Erfinder: Thoener, Manfred, 63599 Biebergemünd (DE); Sailer, Bernd, 63755 Alzenau (DE)
(74) Vertreter: Kohler Schmid Möbus Patentanwälte

(56) Entgegenhaltungen:
- EP-A1- 2 779 258
- EP-B1- 1 983 583
- DE-A1-102012 218 222
- JP-A- 2009 004 128

## Beschreibung

Die Erfindung betrifft Halbzeugdraht für einen Nb3Sn-haltigen Supraleiterdraht, umfassend:
- ein Cu-Stabilisierungshüllrohr,
- eine ringförmig geschlossene Diffusionsbarriere im Inneren des Cu-Stabilisierungshüllrohrs,
- eine Vielzahl von PIT-Elementen im Inneren der Diffusionsbarriere, jeweils umfassend
   ∘ eine Cu-haltige Umhüllung,
   ∘ ein Röhrchen, und
   ∘einen Sn-haltigen Pulverkern.

Die Erfindung betrifft weiterhin ein Verfahren zur Herstellung eines solchen Halbzeugdrahts.

Ein solcher Halbzeugdraht und ein Verfahren zu dessen Herstellung sind in der EP 1 983 583 B1 bekannt geworden.

Nb3Sn-Supraleiterdrähte werden dazu eingesetzt, große elektrische Ströme mit praktisch verlustfrei zu führen, insbesondere in supraleitenden Magnetspulen zur Erzeugung starker Magnetfelder. Nb3Sn kann im Vergleich zu anderen metallischen Supraleitermaterialien (wie NbTi) höhere Stromdichten erreichen und in höheren Magnetfeldern eingesetzt werden, ist aber ein relativ sprödes Material, das nicht (bzw. nur in minimalem Umfang) plastisch verformt werden kann; insbesondere kann Nb3Sn keinem Drahtziehen unterzogen werden.

Nb3Sn-Supraleiterdrähte werden daher im Allgemeinen produziert, indem zunächst ein Halbzeugdraht, der gut plastisch verformbar ist und die zur Bildung des Nb3Sn benötigten chemischen Elemente enthält, hergestellt wird und in die gewünschten Form für die gewünschte Anwendung gebracht wird, etwa als Solenoidspule aufgewickelt wird. Sodann erfolgt ein Reaktionsglühen, während dessen die spröde supraleitende A15-Phase entsteht.

Die Herstellung von Nb3Sn-Supraleiterdrähten erfolgt in der Praxis meist über die "Bronze-Route", bei der im Halbzeugdraht Nb-Stäbe in einer Matrix aus einer CuSn-Legierung ("Bronze") angeordnet werden; solche Halbzeugdrähte sind gut verform- und ziehbar. In der "Internal Tin" (internes Zinn)-Route werden im Halbzeugdraht Nb-Stäbe und Sn-Blöcke, oft in einer Cu-Matrix, vorgesehen; hierbei können große Mengen an Zinn bereitgestellt und ein entsprechend großer Flächenanteil aus Nb3Sn im fertigen Draht erreicht werden, aber das im Vergleich zu Kupfer recht weiche Zinn erschwert die Handhabung des Halbzeugdrahts, insbesondere beim Ziehen. Bei der "Powder in Tube" (PIT, Pulver im Rohr)-Route wird üblicherweise Sn-haltiges Pulver in Nb-Röhrchen angeordnet; auch hier können hohe Mengen an Sn bereit gestellt werden und hohe Stromtragfähigkeiten erreicht werden.

Aus der EP 1 983 583 B1 ist es bekannt geworden, einen Halbzeugdraht für einen Nb3Sn- Supraleiterdraht herzustellen, indem in einem Außenmantel ein Bündel von hexagonalen PIT-Elementen angeordnet wird. Der Außenmantel umfasst ein äußeres Hüllrohr aus Cu, ein mittleres Hüllrohr aus Ta und ein inneres Hüllrohr aus Cu; der Außenmantel wird durch hydrostatisches Strangpressen gefertigt, wobei nach dem Strangpressen ein Kern ausgebohrt wird. Die PIT-Elemente umfassen jeweils ein einen Cu-Mantel und einen pulvermetallurgischen Kern. Der Außenmantel mit enthaltenen PIT-Elementen wird mittels Ziehen und Zwischenglühungen verformt, und schließlich einem Reaktionsglühen unterzogen. Das mittlere Hüllrohr hat einen Anteil von 10-25% am Gesamtmultifilament und dient der mechanischen Verstärkung, so dass die Fließgrenze erhöht wird. Dadurch kann der fertige Nb3Sn-Supraleiterdraht den in Magnetsystemen auftretenden Lorentzkräften besser wiederstehen, und so höhere Stromtragfähigkeiten ermöglichen.

Die EP 1 983 582 A2 beschreibt einen ähnlichen Halbzeugdraht, bei dem hexagonale PIT-Elemente von hexagonalen Verstärkungsfilamenten umgeben sind, die jeweils einen mit Cu umhüllten Ta-Kern aufweisen. Die PIT-Elemente und die Verstärkungsfilamente sind in einem Cu-Außenmantel angeordnet. Die Verstärkungsfilamente dienen wiederum der mechanischen Verstärkung

Supraleiterdrähte enthalten neben supraleitendenden Filamenten auch eine elektrisch gut leitfähige, normalleitende Phase, typischerweise aus hochreinem Cu. Die gut leitfähige, normalleitende Phase stellt einen zu den supraleitenden Filamenten parallelen Strompfad zur Verfügung und übernimmt im Falle des Übergangs des Supraleiters in den normalleitenden Zustand den in den zuvor supraleitenden Filamenten fließenden Strom. Dadurch wird eine Zerstörung des Supraleiterdrahtes verhindert.

Aus der DE 10 2012 218 222 A1 ist ein Halbzeugdraht für einen Nb3Sn-Supraleiterdraht auf Basis einer "Internal Tin"-Route bekannt geworden. Eine Vielzahl von hexagonalen Nb-haltigen Elementen, eine zentrale Sn-haltige Struktur und eine Cu-Matrix sind in einem Cu-Hüllrohr mit einer innenseitigen Diffusionsbarriere aus Ta und/oder Nb angeordnet. Die Diffusionsbarriere verhindert eine Eindiffusion von Sn in das Cu-Hüllrohr und damit eine Verschlechterung der elektrischen Eigenschaften dieser Cu-Stabilisierung. Ein ähnlicher Nb3Sn-Supraleiterdraht ist auch aus der EP 2 713 413 A2 bekannt geworden.

Aus der DE 10 2004 035 852 B4 ist eine Ausgangs-Filamentstruktur auf Basis von "Powder in Tube" für ein supraleitfähiges Leiterelement mit Nb3Sn bekannt geworden, wobei eine Vielzahl von Filamenten in einer Cu-Matrix angeordnet ist. Jedes Filament weist eine Nb-haltige Röhre gefüllt mit Pulver von Sn oder einer Sn-Legierung auf. Jede Röhre ist mit einer Ta-Hülle umgeben, um eine Diffusion von Sn in die Cu-Matrix zu verhindern. Ein Einkernleiter auf Basis von "Powder in Tube" mit einer Ta-Barriere ist auch aus der EP 1 705 721 B1 bekannt.

Die US 4,411,712 schlägt vor, Nb-Stäbe mit einer CuSn-Legierung zu umhüllen, und diese gebündelt in einem Rohr aus hochreinem Cu anzuordnen. Das Rohr kann mit einer Schicht aus einem die Diffusion von Sn verhindernden Material, etwa aus Ta, versehen sein, um eine hohe Leitfähigkeit des hochreinen Cu zu erhalten.

Aus der WO 2006/011170 A1 ist weiterhin für einen MgB2-Supraleiterdraht eine ringförmige Diffusionsbarriere um einen leitfähigen Kern bekannt geworden, der von MgB2-Filamenten umgeben ist.

### Aufgabe der Erfindung

Der Erfindung liegt die Aufgabe zugrunde, einen Halbzeugdraht für einen Nb3Sn-haltigen Supraleiterdraht und ein Verfahren zur Herstellung eines solchen Halbzeugdrahts zur Verfügung zu stellen, mit dem eine besonders hohe Stromtragfähigkeit erreicht werden kann, und gleichzeitig eine hohe Leitfähigkeit einer Cu-Stabilisierung sichergestellt werden kann.

### Kurze Beschreibung der Erfindung

Diese Aufgabe wird gelöst durch einen Halbzeugdraht der eingangs genannten Art, der dadurch gekennzeichnet ist, dass das Röhrchen aus Nb oder einer Nb-haltigen Legierung besteht, dass die Diffusionsbarriere im Querschnitt des Halbzeugdrahts einen Flächenanteil ADF aufweist mit 3 % ≤ ADF ≤ 9 % und weiterhin eine Wandstärke WDF aufweist mit 8 µm ≤ WDF ≤ 25 µm, und dass im Inneren der Diffusionsbarriere weiterhin mehrere Füllelemente angeordnet sind, die innenseitig an den PIT-Elementen anliegen.

Die Aufgabe wird weiterhin gelöst durch Verfahren zur Herstellung eines erfindungsgemäßen Halbzeugdrahts, mit folgenden Schritten:
a) ein Außenmantel wird durch Strangpressen, insbesondere hydrostatisches Strangpressen, gefertigt, wobei der Außenmantel ein Vor-Cu-Stabilisierungshüllrohr, eine Vor-Diffusionsbarriere innerhalb des Vor-Cu-Stabilisierungshüllrohrs und ein Vor-Innenelement innerhalb der Vor-Diffusionsbarriere umfasst, wobei das Material für das Vor-Innenelement so gewählt ist, dass unmittelbar vor der plastischen Verformung durch das Strangpressen eine mittlere Korngröße MKI des Materials für das Vor-Innenelement maximal 3-mal so groß ist wie eine mittlere Korngröße MKD des Materials für die Vor-Diffusionsbarriere,
b) zumindest ein Teil des Vor-Innenelements wird über die Länge des Außenmantels aus dem Außenmantel entfernt,
c) eine Vielzahl von Vor-PIT-Elementen wird zusammen mit mehreren Vor-Füllelementen innerhalb der Vor-Diffusionsbarriere angeordnet, wobei die Vor-Füllelemente an einer Innenseite des verbliebenen Außenmantels und an den Vor-PIT-Elementen anliegen,
d) der so erhaltene Vor-Halbzeugdraht wird einer querschnittsreduzierenden Umformung unterzogen, wodurch der Halbzeugdraht erhalten wird.

Im Rahmen der vorliegenden Erfindung ist es vorgesehen, bei einem "Power in Tube"-Halbzeugdraht eine Diffusionsbarriere für Sn vorzusehen, in deren Innerem eine Vielzahl (typischerweise 50 oder mehr, meist 100 oder mehr) PIT-Elemente angeordnet werden. Die Diffusionsbarriere blockiert eine Diffusion von Sn aus dem Inneren des Halbzeugdrahts, insbesondere aus den PIT-Elementen, in das Cu-Stabilisierungshüllrohr während eines Reaktionsglühens. Dadurch wird eine Verunreinigung des Cu-Stabilisierungshüllrohrs (das aus hochreinem Kupfer besteht) vermieden, so dass ein hohes Restwiderstandsverhältniss RRR im Cu-Stabilisierungsrohr zuverlässig erreicht werden kann.

Im Rahmen der Erfindung wird der Flächenanteil für eine Diffusionsbarriere zum Schutz des Cu-Stabilisierungsrohrs minimiert. Dadurch wird es möglich, einen größeren Flächenanteil dem fertigen Supraleiter zur Verfügung zu stellen, und damit die Stromtragfähigkeit zu erhöhen

Im Rahmen der Erfindung wird die ringförmig geschlossene Diffusionsbarriere für eine Vielzahl von PIT-Elementen eingesetzt, was zum einen die Herstellung des Halbzeugdrahts vereinfacht, und zum anderen den Flächenbedarf für den Schutz der Cu-Stabilisierung gering hält.

Weiterhin wird der Flächenanteil der einen, umlaufenden Diffusionsbarriere im Halbzeugdraht insgesamt geringer gewählt, als dies bisher beispielsweise für Ta-Mittelrohre bei Halbzeugdrähten in der "Powder in Tube"-Route üblich war. Im Rahmen der "Power in Tube"-Route wurde ein Ta-Mittelrohr zur mechanischen Stabilisierung mit einem Flächenanteil von 10-25% eingesetzt, vgl. die EP 1 983 583 B1. Im Rahmen der Erfindung wurde erkannt, dass für die Funktion als Diffusionssperre in der "Powder in Tube"-Route ein Mittelrohr bestehend aus für Sn durch Diffusion beim Reaktionsglühen nicht durchdringbarem Material ("Diffusionsbarriere"), wie Tantal oder Niob, ein Flächenanteil am Halbzeugdraht von 9% oder weniger, bevorzugt 8% oder weniger, und besonders bevorzugt 7% oder weniger, ausreichend ist.

Entsprechend wird im Rahmen der Erfindung im (bereits gezogenen) Halbzeugdraht eine Wandstärke der Diffusionsbarriere von 25 µm oder weniger, bevorzugt 22 µm oder weniger, besonders bevorzugt 20 µm oder weniger, eingesetzt.

Um diese geringen Wandstärken der Diffusionsbarriere erreichen zu können, und gleichzeitig sicherstellen zu können, dass die Diffusionsbarriere nirgends an ihrem Umfang eine Undichtigkeit (Öffnung) aufweist, sind die PIT-Elemente erfindungsgemäß an Füllelemente angelegt, die wiederum an der Innenseite eines (umgeformten) Außenmantels des Halbzeugdrahts anliegen; in der Regel liegen die PIT-Elemente nicht unmittelbar an der Innenseite des (umgeformten) Außenmantels an.

Vor der querschnittsreduzierenden Umformung des noch nicht verformten Halbzeugdrahts ("Vor-Halbzeugdraht") kann so das Innere des Außenmantels mittels der Vor-Füllelemente und der Vor-PIT-Elemente praktisch hohlraumfrei befüllt werden. Dadurch wird die Welligkeit der Diffusionsbarriere nach der querschnittsreduzierenden Umformung reduziert; insbesondere kommt es zu keiner Welligkeit bedingt durch die Auffüllung von Hohlräumen nahe der Innenseite des Außenmantels. Je geringer die Welligkeit, desto geringer ist das Risiko einer Undichtigkeit (Öffnung) in der Diffusionsbarriere.

Man beachte, dass hier Strukturen des Halbzeugdrahts vor der querschnittsreduzierenden Umformung, die Strukturen des Halbzeugdrahts nach der querschnittsreduzierenden Umformung entsprechen, mit dem Zusatz "Vor-" gekennzeichnet sind.

Eine weitere Reduzierung der Welligkeit der Diffusionsbarriere wird im Rahmen des erfindungsgemäßen Verfahrens dadurch erreicht, dass für die Vor-Diffusionsbarriere und das Vor-Innenelement Materialien mit aufeinander abgestimmter Korngröße verwendet werden. Erfindungsgemäß ist vorgesehen, dass für die mittlere Korngröße MKI des (metallischen) Materials für das Vor-Innenelement und die mittlere Korngröße MKD des (metallischen) Materials für die Vor-Diffusionsbarriere gilt MKI < 3*MKD. Bevorzugt gilt weiter MKI ≤ 1·MKD. Die Angaben beziehen sich auf die Situation unmittelbar vor dem Strangpressen, also nachdem das Material jeweils auf die Stangpresstemperatur erwärmt wurde, aber bevor die Matrize der Strangpresse passiert wurde.

Das Material für das Vor-Innenelement darf erfindungsgemäß im Verhältnis zum Material für die Diffusionsbarriere nicht zu grobkörnig sein. Dadurch wird einer Welligkeit entlang des Umfangs der Vor-Diffusionsbarriere oder gar einer axialen Furchenbildung in der Vor-Diffusionsbarriere, insbesondere an der dem Vor-Innenelement zugewandten Seite der Vor-Diffusionsbarriere, vorgebeugt, die bei der weiteren querschnittsreduzierenden Umformung zu einer noch größeren Welligkeit und schließlich der Bildung von Lücken in der Diffusionsbarriere führen kann. Typischerweise beträgt MKI maximal 50 µm, bevorzugt 15-40 µm. MKD beträgt typischerweise maximal 90 µm, und bevorzugt 35-60 µm bei Ta und 25-45 µm bei Nb.

Man beachte, dass bei der Erwärmung der Materialien für den Außenmantel vor dem Strangpressen (typischerweise auf wenigstens 450°C, meist ca. 500°C) ein merkliches Kornwachstum eintreten kann. Aus diesem Grund ist reines Kupfer, insbesondere mit Gussgefüge, welches eine erhebliche Korngröße aufweist und weiteres Kornwachstum in diesem Temperaturbereich zeigt, als Material für das Vor-Innenelement in der Regel nicht geeignet. In der Praxis bewährt haben sich vor allem Cu-Legierungen, insbesondere CuSn, als Material für das Vor-Innenelement.

Das Vorhandensein des Vor-Innenelements ist für die Strangpressumformung besonders vorteilhaft, da auf Grund der Reibungsverhältnisse ein Kontakt zwischen der Nb- oder Ta-Vor-Diffusionsbarriere und dem Strangpresswerkzeug problematisch ist. Nach dem Strangpressen wird zumindest ein Teil der Querschnittsfläche des Vor-Innenelements entfernt, um den für Nb3Sn verfügbaren Querschnittsanteil möglichst groß zu halten.

Durch die erfindungsgemäßen Maßnahmen kann sichergestellt werden, dass die Diffusionsbarriere während der Fertigung des Halbzeugdrahts, trotz ihres geringen Flächenanteils im Querschnitt bzw. ihrer geringen Wandstärke, keine Undichtigkeiten bekommt, die beim anschließenden Reaktionsglühen zu einer Sn-Kontamination des hochreinen Kupfers im Cu-Stabilisierungshüllrohr führen könnte. Insbesondere kann auch dann eine zuverlässige Dichtwirkung zur Verfügung gestellt werden, wenn Deformationen, wie sie beim Fertigen von (Halbzeug-)Kabeln üblicherweise auftreten, in den Halbzeugdraht eingebracht werden.

Aufgrund der zuverlässigen Dichtwirkung der Diffusionsbarriere kann die Stoffumsetzung von Nb (und ggf. ergänzenden Elementen) und Sn in den PIT-Elementen zur supraleitenden A15-Phase mit einem besonders hohen Umsetzungsgrad (Anteil des reagierten Nb im Verhältnis zum eingesetzten Nb) geführt werden, da ein Durchbruch von Sn durch die Nb-haltigen Röhrchen grundsätzlich unbedenklich ist. Dafür kann, verglichen mit herkömmlichen Halbzeugdrähten auf Basis von "Powder in Tube", zum einen die Reaktionsglühzeit erhöht und/oder die Reaktionsglühtemperatur erhöht werden, oder auch der Sn-Gehalt des Pulvers in den Nb-haltigen Röhrchen erhöht werden. Insbesondere kann der Flächenverlust durch die Diffusionsbarriere bezüglich der Stromtragfähigkeit gegenüber einem "Powder in Tube"-Supraleiterdraht ohne Diffusionsbarriere überkompensiert werden.

Insgesamt kann daher im Rahmen der Erfindung eine besonders hohe Stromtragfähigkeit des fertigen Nb3Sn-haltigen Supraleiterdrahts erreicht werden, wobei dieser zuverlässig ein hohes Restwiderstandsverhältnis (RRR-Wert) aufweisen kann. Im Rahmen der Erfindung kann insbesondere eine Stromtragfähigkeit von 1400 A/mm² (bei 15 T und 4,2 K) bzw. 2400 A/mm² (bei 12 T und 4,2 K) und mehr bezogen auf den Supraleiterflächenanteil im Gesamtquerschnitt des Drahtes und ein RRR-Wert im Stabilisierungskupfer von 150 oder mehr erreicht werden.

### Bevorzugte Ausführungsformen und Varianten der Erfindung

### Ausführungsformen des Halbzeugdrahts

Bei einer vorteilhaften Ausführungsform des erfindungsgemäßen Halbzeugdrahts ist vorgesehen, dass die Füllelemente außenseitig unmittelbar an der Diffusionsbarriere anliegen. Ein beim Strangpressen eingebrachtes Vor-Innenelement ist also vor dem Einbringen der Vor-Füllelemente und der Vor-PIT-Elemente vollständig entfernt worden. Dadurch wird ein für die Supraleitung nicht zur Verfügung stehender Flächenanteil im Querschnitt des späteren Supraleiterdrahts minimiert, und umgekehrt die Stromtragfähigkeit maximiert.

Bevorzugt ist auch eine Ausführungsform, bei der ein zentrales Füllelement außenseitig an die PIT-Elemente grenzt. Das zentrale Füllelement kann durch sein Material auf die über den Querschnitt des Halbzeugdrahts hier besonders hohen mechanischen Belastungen bei der querschnittsreduzierenden Umformung, insbesondere Ziehen, abgestimmt sein; insbesondere kann das zentrale Füllelement aus Kupfer bestehen. Typischerweise entspricht das zentrale Füllelement in seiner Kontur einem Hexagonalelement oder einem Bündel von Hexagonalelementen, so dass Hohlräume um das zentrale Füllelement herum vermieden werden können. Man beachte, dass die PIT-Elemente dann typischerweise ebenfalls mit einem hexagonalen Querschnitt versehen sind.

Bevorzugt ist weiterhin eine Ausführungsform, bei der die Füllelemente Cuhaltig sind. Cu-haltige Füllelemente weisen ein besonders gutes Verformungsverhalten auf. Die Füllelemente können insbesondere elementares Kupfer enthalten.

Vorteilhaft ist eine Ausführungsform, bei der die PIT-Elemente einen hexagonalen Querschnitt aufweisen. Dies vereinfacht die Handhabung und eine dichte, gleichmäßige Packung im Halbzeugdraht.

Bei einer bevorzugten Ausführungsform ist vorgesehen, dass die Röhrchen aus Nb oder der Nb-haltigen Legierung in den PIT-Elementen einen runden Querschnitt aufweisen. Dadurch ist über den gesamten Umfang der Röhrchen eine gleichmäßige Restdicke von unreagiertem Röhrchenmaterial bei bzw. nach dem Reaktionsglühen möglich, wodurch ein hoher Umsetzungsgrad zu Nb3Sn und damit eine hohe Stromtragfähigkeit besser erreichbar ist.

Bevorzugt ist auch eine Ausführungsform, bei der für den Flächenanteil ADF der Diffusionsbarriere gilt 4 %≤ 5 ADF ≤ 8 %. Dies hat sich in der Praxis bewährt. Durch einen höheren Mindestanteil der Diffusionsbarriere wird die Gefahr einer Sn-Kontamination im Cu-Stabilisierungshüllrohr verringert, und durch den niedrigeren Maximalanteil der Diffusionsbarriere wird der nicht für die Supraleitung zur Verfügung stehende Querschnittsanteil reduziert.

Ebenfalls bevorzugt ist vorgesehen, dass das Cu-Stabilisierungshüllrohr im Querschnitt des Halbzeugdrahts einen Flächenanteil ASH aufweist mit 12 % ≤ ASH ≤ 30 %, bevorzugt 18 %≤ ASH ≤ 30 %, besonders bevorzugt 22 % ≤ ASH ≤ 27 %. Dieser Flächenanteil kann eine gute Stabilisierungsfunktion (thermisch und elektrisch) zur Verfügung stellen und schränkt gleichzeitig den für die Supraleitung zur Verfügung stehenden Flächenanteil des Drahtquerschnitts nicht unnötig ein.

Bei einer weiteren, bevorzugten Ausführungsform gilt für die Wandstärke WDF der Diffusionsbarriere 10 µm ≤ WDF ≤ 22 µm. Auch dies hat sich in der Praxis bewährt. Mit der höheren Mindestdicke der Diffusionsbarriere wird die Gefahr einer Sn-Kontamination im Cu-Stabilisierungshüllrohr verringert, und durch die niedrigere Maximaldicke der Diffusionsbarriere wird der nicht für die Supraleitung zur Verfügung stehende Querschnittsanteil reduziert.

Vorteilhafter Weise sieht eine Ausführungsform vor, dass das Cu-Stabilisierungshüllrohr einen Außendurchmesser DSH aufweist mit 0,5 mm ≤ DSH ≤ 1,2 mm, bevorzugt 0,6 mm ≤ DSH ≤ 0,9 mm. In diesem Fall ist die Wandstärke der Diffusionsbarriere optimal auf die Größe des Cu-Stabilisierungshüllrohrs bzw. des Halbzeugdrahts oder auch des (bezüglich der Dimensionen im Querschnitt gleichen) Supraleiterdrahts abgestimmt.

Bevorzugt ist auch eine Ausführungsform, bei der die Röhrchen aus Nb oder einer Nb-haltigen Legierung einen Durchmesser DRö aufweisen mit 20 µm ≤ DRö ≤ 55 µm, bevorzugt 20 µm DRö ≤ 45 µm. Mit dieser Größe können im fertigen Supraleiterdraht besonders geringe Magnetisierungsverluste erreicht werden, insbesondere geringere als in einem typischen "Internal Tin"-Draht.

Bei einer vorteilhaften Ausführungsform ist vorgesehen, dass in den Sn-haltigen Pulverkernen ein Gesamt-Sn-Anteil GSn von wenigstens 80 Massen-% enthalten ist, insbesondere wobei 85 Massen-% ≤ GSn ≤ 90 Massen-%.

Bevorzugt ist auch GSn ≥ 82 Massen-%; besonders bevorzugt ist GSn ≥ 85 Massen-%. Mit einem hohen Gesamt-Sn-Anteil kann ein hoher Umsetzungsgrad von Nb zu Nb3Sn erreicht werden, und damit eine besonders hohe Stromtragfähigkeit im fertigen Supraleiterdraht.

Besonders bevorzugt ist eine Ausführungsform, bei der die Diffusionsbarriere wenigstens 50 Massen-% Nb oder wenigstens 50 Massen-% Ta enthält. Ta als Material der Diffusionsbarriere wirkt auch als mechanische Verstärkung und vermeidet die Gefahr der Bildung von Nb3Sn in der Diffusionsbarriere während der Wärmebehandlung; bevorzugt enthält daher eine Diffusionsbarriere auf Basis einer Ta-Legierung kein Niob. Ferner führt eine Ta-Barriere zu einer kleineren Magnetisierung im reaktionsgeglühten Nb3Sn haltigen Draht. Eine Diffusionsbarriere aus Nb oder einer Nb-Legierung ist vergleichsweise preisgünstig, insbesondere im Vergleich zu Ta; bevorzugt enthält daher eine Diffusionsbarriere auf Basis einer Nb-Legierung kein oder allenfalls wenig Ta (beispielsweise 10 Massen-% oder weniger). Man beachte jedoch, dass auch NbTa-Legierungen oder Materialien bzw. Legierungen auf Basis von Hafnium, Zirkon, Vanadium, Molybdän oder Titan als Material für die Diffusionsbarriere verwendet werden können.

In den Rahmen der vorliegenden Erfindung fällt auch ein Halbzeugkabel für ein Nb3Sn-haltiges Supraleiterkabel, umfassend mehrere verseilte, erfindungsgemäße Halbzeugdrähte, insbesondere wobei das Halbzeugkabel als ein Flachkabel ausgebildet ist. Mit einem Supraleiterkabel, das aus dem Halbzeugkabel erhalten wird, können sehr hohe Ströme supraleitend transportiert werden. Die geschlossene Diffusionsbarriere kann auch bei Verformungen, wie sie etwa bei der Fertigung von Flachkabeln auftreten, weiter zuverlässig eine Sperrfunktion für Sn zu den Cu-Stabilisierungshüllrohren wahrnehmen und so einen hohen RRR-Wert auch im reaktionsgeglühten Flachkabel sicherstellen.

Ebenfalls in den Rahmen der vorliegenden Erfindung fällt ein Nb3Sn-haltiger Supraleiterdraht oder Nb3Sn-haltiges Supraleiterkabel, hergestellt durch Reaktionsglühen eines erfindungsgemäßen Halbzeugdrahts oder eines erfindungsgemäßen Halbzeugkabels. Durch die erfindungsgemäße Halbzeugdrahtgestaltung kann eine hohe Stromtragfähigkeit in den Supraleiterdrähten bei gleichzeitig hoher elektrischer Leitfähigkeit in den normalleitenden Cu-Stabilisierungshüllrohren sichergestellt werden.

Besonders bevorzugt ist dabei eine Ausführungsform eines erfindungsgemäßen Nb3Sn-haltigen Supraleiterdrahts oder eines erfindungsgemäßen Nb3Sn-haltigen Supraleiterkabels, wobei beim Reaktionsglühen das in den Röhrchen enthaltene Nb zu wenigstens 80 % zu einer A15-Phase reagiert worden ist. Ein solch hoher Umsetzungsgrad (und eine entsprechend hohe Stromtragfähigkeit) ist im Rahmen der Erfindung gut zugänglich, da ein etwaiges Durchbrechen der Reaktionsfront von Nb3Sn bzw. der A15-Phase durch das Röhrchen aus Nb oder einer Nb-haltigen Legierung wegen der Diffusionsbarriere grundsätzlich unkritisch ist, und insbesondere nicht zu einer Kontamination des Cu-Stabilisierungshüllrohrs mit Sn führt.

Ebenfalls bevorzugt ist eine Ausführungsform, bei der der Nb3Sn-haltige Supraleiterdraht oder das Nb3Sn-haltige Supraleiterkabel ein Restwiderstandsverhältnis RRR von wenigstens 100, bevorzugt wenigstens 150 aufweist. Solche Restwiderstandsverhältniswerte sind im Rahmen der Erfindung zuverlässig zugänglich.

### Varianten des Verfahrens zur Herstellung des Halbzeugdrahts

Bei einer bevorzugten Variante des erfindungsgemäßen Verfahrens weist das Material für das Vor-Cu-Stabilisierungshüllrohr unmittelbar vor der plastischen Verformung durch das Strangpressen eine mittlere Korngröße MKS auf, wobei gilt MKS ≥ 2·MKI, bevorzugt MKS ≥ 5·MKI. Mit anderen Worten, das Material für das Vor-Innenelement ist deutlich feiner als das Material für das Cu-Stabilisierungshüllrohr. Damit kann eine sehr geringe Welligkeit der Vor-Diffusionsbarriere nach dem hydrostatischen Strangpressen erreicht werden. MKS beträgt typischerweise 100 µm oder mehr, meist um 200-500 µm.

Bevorzugt ist weiterhin eine Variante, bei der in Schritt d) der Vor-Halbzeugdraht einem Strangpressen und/oder Ziehen und/oder Drahtwalzen unterzogen wird. Diese Verfahren haben sich zur querschnittsreduzierenden Umformung bewährt.

Ebenfalls bevorzugt ist eine Variante, bei der unmittelbar vor dem Strangpressen die Materialien für den Außenmantel auf eine Temperatur TSP ≥ 450°C aufgeheizt sind. Dadurch wird ein gutes Verformungsverhalten erreicht.

Vorteilhafter Weise wird bei einer Variante als Vor-Innenelement in Schritt a) ein Hohlzylinder ausgebildet. Dadurch kann das hydrostatische Strangpressen materialsparend geführt werden, und es braucht nur vergleichsweise wenig Material vor dem Einfügen der Vor-PIT-Elemente entfernt zu werden, um für letztere einen großen Flächenanteil des Querschnitts zur Verfügung stellen zu können. Alternativ kann als Vor-Innenelement ein Vollzylinder ausgebildet werden, was die Nutzung einer einfacheren Strangpress-Matrize erlaubt.

Bei einer bevorzugten Variante ist vorgesehen, dass in Schritt b) Material des Vor-Innenelements mechanisch, insbesondere durch Bohren oder Fräsen, abgetragen wird. Ein mechanisches Abtragen kann einfach und schnell ausgeführt werden.

Alternativ oder zusätzlich ist bei einer Variante vorgesehen, dass in Schritt b) Material des Vor-Innenelements chemisch abgetragen wird. Das chemische Abtragen ist materialschonend, und bringt insbesondere keine Verformungen in die Materialoberflächen ein. Falls sowohl ein oder mehrere mechanische als auch ein oder mehrere chemische Abtragungsschritte angewandt werden, so ist bevorzugt der letzte Abtragungsschritt ein chemisches Abtragen.

Besonders vorteilhaft ist eine Variante, bei der in Schritt b) das Vor-Innenelement vollständig aus dem Außenmantel entfernt wird. Dadurch wird ein besonders großer Flächenanteil des Querschnitts für die Supraleitung bereit gestellt. Das Vor-Innenelement dient dann vor allem zur Verbesserung des Verformungsverhaltens beim Strangpressen.

Bevorzugt ist auch eine Variante, bei der das Material für das Vor-Innenelement als eine Cu-Sn-, Cu-Ni-, Cu-Zn- oder eine Cu-Al-haltige Legierung gewählt ist. Mit diesen Legierungen können relativ kleine mittlere Korngrößen, und insgesamt feinkörnige Gefüge, im Material für das Vor-Innenelement erhalten werden, insbesondere auch beim Erwärmen für das Strangpressen auf 450°C oder mehr.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Die nicht maßstabsgetreuen Abbildungen zeigen:
- Fig. 1: einen schematischen Querschnitt einer ersten Ausführungsform eines erfindungsgemäßen Halbzeugdrahts, mit einem Innenelement;
- Fig. 2: einen schematischen Querschnitt einer zweiten Ausführungsform eines erfindungsgemäßen Halbzeugdrahts, mit direkt an der Diffusionsbarriere anliegenden Füllelementen;
- Fig. 3: einen schematischen Querschnitt einer dritten Ausführungsform eines erfindungsgemäßen Halbzeugdrahts, mit einem zentralen Füllelement;
- Fig. 4: einen schematischen Querschnitt durch ein einzelnes PIT-Element für einen erfindungsgemäßen Halbzeugdraht;
- Fig. 5: eine schematische Übersicht zum Ablauf eines Verfahrens betreffend die Herstellung eines erfindungsgemäßen Halbzeugdrahts, Teilschritte a) und b) in einer ersten Verfahrensvariante, mit einem als Hohlzylinder ausgebildeten Vor-Innenelement;
- Fig. 6: eine schematische Übersicht zum Ablauf eines Verfahrens betreffend die Herstellung eines erfindungsgemäßen Halbzeugdrahts, Teilschritte a) und b) in einer zweiten Verfahrensvariante, mit einem als Vollzylinder ausgebildeten Vor-Innenelement;
- Fig. 7: eine schematische Übersicht zum Ablauf eines Verfahrens betreffend die Herstellung eines erfindungsgemäßen Halbzeugdrahts, Teilschritte c) und d), unter Verwendung eines Außenmantels mit vollständig entferntem Vor-Innenelement;
- Fig. 8: eine schematische Schrägansicht eines erfindungsgemäßen Halbzeugkabels;
- Fig. 9: eine schematische Ansicht einer mit einem erfindungsgemäßen Halbzeugkabel gewickelten Magnetspule beim Reaktionsglühen;
- Fig. 10a: eine lichtoptische Aufnahme eines Querschliffs eines gemäß Schritt a) des erfindungsgemäßen Verfahrens hergestellten Außenmantels, mit einem Vor-Innenelement aus einer CuSnTi-Legierung;
- Fig. 10b: eine lichtoptische Aufnahme eines Querschliffs eines herkömmlich hergestellten Außenmantels, mit einem Cu-Innenkern.

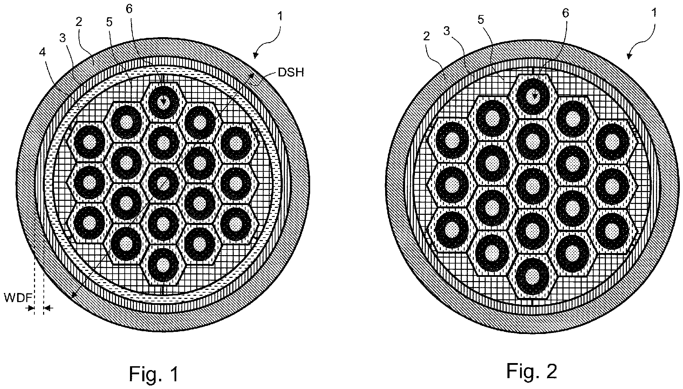

Die **Fig. 1** zeigt in einer schematischen Querschnittsansicht einen erfindungsgemäßen Halbzeugdraht 1 in einer ersten Ausführungsform.

Der Halbzeugdraht 1 weist radial außen ein Cu-Stabilisierungshüllrohr 2 auf, welches aus hochreinem Kupfer (typischerweise mit einer Reinheit von 99,9 atom% oder höher) gefertigt ist. Das Cu-Stabilisierungshüllrohr 2 weist hier einen kreisrunden Außen- und Innenquerschnitt auf. Der Anteil der Fläche des Cu-Stabilisierungshüllrohrs 2 an der Gesamtfläche des Halbzeugdrahts 1 im Querschnitt beträgt bevorzugt ca. 22-27%, meist 24-25%, und der Außendurchmesser DSH des Cu-Stabilisierungshüllrohrs 2 bzw. des Halbzeugdrahts 1 beträgt bevorzugt ca. 0,6-0,9 mm, meist 0,7-0,85 mm.

Innenseitig liegt am Cu-Stabilisierungshüllrohr 2 eine rohrförmige, im Querschnitt ringförmig geschlossene Diffusionsbarriere 3 an. Die Diffusionsbarriere 3 ist hier aus Niob gefertigt und weist bevorzugt eine Wandstärke WDF von 10-20 µm auf. Der Flächenanteil der Diffusionsbarriere 3 an der Gesamtfläche des Halbzeugdrahts 1 im Querschnitt beträgt bevorzugt ca. 4-8 %, meist 5-6%. Die Wandstärke WDF der Diffusionsbarriere 3 ist über ihren Umfang im Wesentlichen konstant, und es liegt auch keine merkliche Welligkeit in der Diffusionsbarriere vor. In der Praxis schwanken der Innenradius und der Außenradius der Diffusionsbarriere 3 im Querschnitt typischerweise jeweils maximal um 10%, bezogen auf den jeweils maximal auftretenden Innenradius und Außenradius.

In der gezeigten Ausführungsform liegt innenseitig an der Diffusionsbarriere 3 ein Innenelement 4 an, welches von einem Vor-Innenelement nach dem hydrostatischen Strangpressen verblieben ist. Das Innenelement 4 ist typischerweise aus einer Kupferlegierung, bevorzugt einer CuSn-Legierung, gefertigt. Die Wandstärke des Innenelements 4 wird bevorzugt möglichst klein eingestellt, typischerweise bei 15 µm oder weniger. Das Innenelement 4 (bzw. das zugehörige Vor-Innenelement) hat die Diffusionsbarriere 3 vor Beschädigungen im Laufe des Herstellungsverfahrens geschützt.

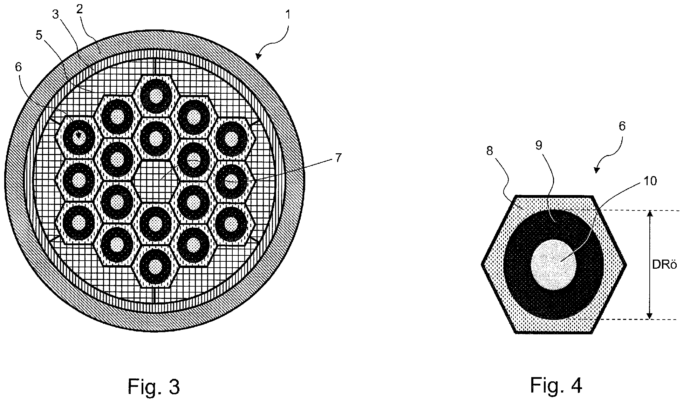

Innen am Innenelement 4 liegt ein Satz von hier sechs Füllelementen 5 an. Die Füllelemente 5 sind außenseitig kreisbogenförmig gekrümmt, entsprechend der anliegenden Innenseite des Innenelements 4, und innenseitig profiliert, entsprechend den anliegenden, hexagonal profilierten PIT-Elementen 6. Die Füllelemente 5 sind typischerweise aus Kupfer gefertigt. In der gezeigten Ausführungsform ist ein Bündel von 19 PIT-Elementen 6 von den Füllelementen 5 umschlossen; es können jedoch auch mehr PIT-Elemente 6, etwa 50 oder mehr PIT-Elemente 6, vorgesehen sein. Die PIT-Elemente 6 werden bei Fig. 4 näher erläutert. Die Diffusionsbarriere 3 verhindert, das aus den PIT-Elementen 6 etwaig austretendes Sn bis in das Cu-Stabilisierungshüllrohr 2 vordringen kann. Entsprechend behält das Cu-Stabiliserungshüllrohr 2 nach dem Reaktionsglühen eine hohe elektrische Leitfähigkeit.

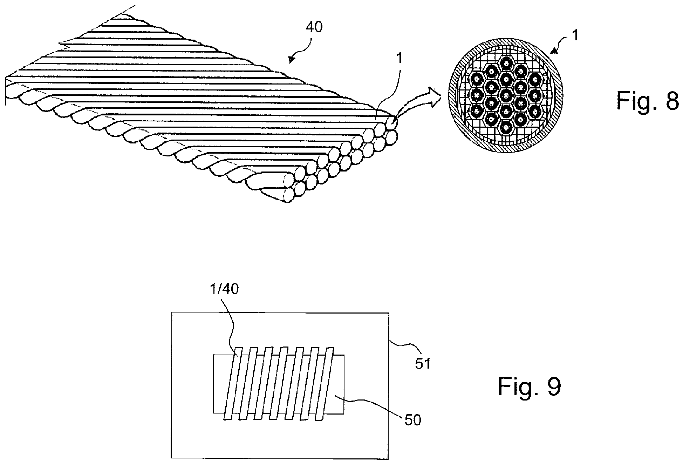

Der gezeigte Halbzeugdraht 1 ist bereits durch geeignete Umformmaßnahmen, beispielsweise Ziehen, auf die für das Reaktionsglühen vorgesehenen Endmaße eingestellt, und kann für die gewünschte Anwendung falls gewünscht gebündelt und positioniert (etwa zu einem Halbzeugkabel verseilt und auf einem Spulenträger aufgewickelt) werden, vgl. dazu Fig. 8 und 9.

Die Fig. 2 zeigt eine zweite Ausführungsform eines erfindungsgemäßen Halbzeugdrahts 1 im schematischen Querschnitt, ähnlich zur in Fig. 1 gezeigten Ausführungsform. Es werden daher nur die wesentlichen Unterschiede erläutert.

In der in Fig. 2 gezeigten Ausführungsform liegen die Füllelemente 5 außenseitig direkt an der Diffusionsbarriere 3 an; ein Innenelement ist nicht vorgesehen. Dadurch ist es möglich, im Inneren der Diffusionsbarriere 3 mehr Fläche für die PIT-Elemente 6 zur Verfügung zu stellen; die PIT-Elemente 6 können entsprechend näher an die Diffusionsbarriere 3 heranrücken.

**Fig. 3** zeigt eine dritte Ausführungsform eines erfindungsgemäßen Halbzeugdrahts 1 im schematischen Querschnitt, ähnlich zu der in Fig. 2 gezeigten Ausführungsform. Es werden daher nur die wesentlichen Unterschiede erläutert.

In der in Fig. 3 gezeigten Ausführungsform ist im Inneren des Bündels von hier 18 PIT-Elementen 6 ein zentrales Füllelement 7 vorgesehen, das hier einen Raum entsprechend einem hexagonalen PIT-Element einnimmt. Man beachte, dass der eingenommene Raum in anderen Ausführungsformen auch mehreren PIT-Elementen, etwa drei oder sieben oder mehr, entsprechen kann. Das zentrale Füllelement 7 ist typischerweise aus demselben Material wie die Füllelemente 5 gefertigt, etwa aus Kupfer. Das zentrale Füllelement 7 vermeidet eine hohe mechanische Belastung auf PIT-Elemente bei einer querschnittsreduzierenden Umformung.

Die **Fig. 4** zeigt im schematischen Querschnitt ein einzelnes PIT-Element 6 für einen erfindungsgemäßen Halbzeugdraht, wie er etwa in den Figuren 1 bis 3 gezeigt ist.

Das PIT-Element 6 weist eine Cu-haltige Umhüllung 8 auf, hier bestehend aus elementarem Kupfer, die außenseitig einen hexagonalen Querschnitt und innenseitig einen kreisrunden Querschnitt aufweist (hierfür wurde beispielsweise zunächst ein hexagonaler Außenquerschnitt gezogen und anschließend eine kreisrunde Bohrung eingebracht). Im Inneren der Cuhaltigen Umhüllung 8 liegt ein Röhrchen 9 aus Nb oder einer Nb Legierung (etwa NbTa) an. Das Röhrchen 9 ist mit einem Pulverkern 10 gefüllt, der Snhaltig ist, beispielsweise mit einer Mischung aus elementarem Sn, Nb6Sn5 und/oder NbSn2, wobei der Gesamtanteil an Sn im Pulverkern typischerweise wenigstens 80 Massen%, bevorzugt wenigstens 82 Massen% beträgt. Der Pulverkern 10 ist typischerweise verdichtet, beispielsweise verpresst.

Die im Querschnitt kreisrunden Röhrchen 9 der PIT-Elemente 6 weisen bevorzugt im auf Enddimension umgeformten Halbzeugdraht einen äußeren Durchmesser DRö von 20-45 µm, meist 30-40 µm auf.

Beim Reaktionsglühen kann Sn aus dem Pulverkern 10 in das Röhrchen 9 eindiffundieren und dort zu Nb3Sn umgesetzt werden. Dabei schreitet eine Reaktionsfront von innen nach außen voran. Im Rahmen der Erfindung wird ein weites Fortschreiten der Reaktionsfront gestattet, so dass typischerweise mindestens 80% des im Röhrchen 9 (einschließlich Pulverkern 10) vorhandenen Nb, und bevorzugt alles vorhandende Nb, zur A15-Phase, insbesondere Nb3Sn, umgesetzt werden. Ein etwaiges Durchbrechen des Sn durch das Röhrchen 9 ist grundsätzlich unkritisch, da die Diffusionsbarriere das Cu-Stabilisierungshüllrohr des Halbzeugdrahts schützt.

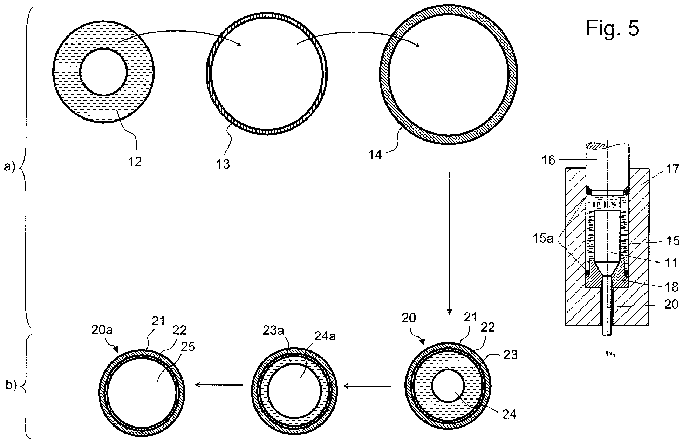

Die **Fig. 5** illustriert in einer ersten Variante einen ersten Teil eines erfindungsgemäßen Verfahrens zur Herstellung eines erfindungsgemäßen Halbzeugdrahtes, etwa eines Halbzeugdrahtes gemäß Fig. 2. Die Figur zeigt überwiegend Querschnitte, bei der Strangpresse rechts jedoch einen Längsschnitt.

Im Rahmen eines ersten Schrittes a) des erfindungsgemäßen Verfahrens wird ein Block 11 einem hydrostatischen Strangpressen unterzogen.

Der Block 11 umfasst hier einen Hohlzylinder 12 aus einem Material für ein Vor-Innenelement, der in ein Rohr 13 aus einem Material für eine Vor-Diffusionsbarriere eingesteckt ist, und weiterhin ein Rohr 14 aus einem Material für ein Vor-Cu-Stabilisierungshüllrohr, in das das Rohr 13 mitsamt dem Hohlzylinder 12 eingesteckt ist.

Der Block 11 wird in einer Druckflüssigkeit 15 in einem Rezipienten 17 angeordnet. Mittels eines Pressstempels 16 wird die Druckflüssigkeit 15, abgedichtet durch die Hochdruckdichtungen 15a, mit Druck (typischerweise mehr als 10 kbar) beaufschlagt und der Block 11 durch eine sich verengende Matrize 18 extrudiert. Der Block 11 wird beheizt, so dass dieser unmittelbar vor und auch beim Extrudieren eine Temperatur TSP von 450°C oder mehr aufweist, meist ca. 500°C.

Das (metallische) Material für das Vor-Innenelement und das (metallische) Material für die Vor-Diffusionsbarriere sind so gewählt, dass die unmittelbar vor dem Extrudieren (also nach der Erwärmung für das Extrudieren, aber vor dem Eintritt in die Matrize 18) für eine mittlere Korngröße MKI des Materials für das Vor-Innenelement und eine mittlere Korngröße MKD des Materials für die Vor-Diffusionsbarriere gilt: MKI ≤ 3*MKD, bevorzugt MKI ≤ 1*MKD. Typischerweise gilt auch unmittelbar vor dem Extrudieren weiterhin für eine mittlere Korngröße MKS des (metallischen) Materials für das Vor-Cu-Stabilisierungshüllrohr: MKS ≥ 2*MKI, bevorzugt MKS ≥ 5*MKI.

Durch das Extrudieren des Blocks 11 wird ein Außenmantel 20 erhalten, der einen kleineren Außendurchmesser als der Block 11 hat. Der Außenmantel 20 besteht aus einem Vor-Stabilisierungshüllrohr 21, einer in diesem innenseitig anliegenden Vor-Diffusionsbarriere 22, und einem in dieser innenseitig anliegenden Vor-Innenelement 23, das hier hohl (rohrförmig) mit einem zentralen Hohlraum 24 ausgebildet ist. Durch die obigen Gefügevorgaben für die Materialien, die beim hydrostatischen Strangpressen umgeformt werden, kann die Welligkeit in der Vor-Diffusionsbarriere 22 (die die Welligkeit der späteren Diffusionsbarriere im Halbzeugdraht bzw. im fertigen Supraleiterdraht mit bestimmt) gering gehalten werden.

Im zweiten Schritt b) des Verfahrens wird nun Material des Vor-Innenelements 23 abgetragen. In der gezeigten Variante wird der Durchmesser des zentralen Hohlraum 24 zunächst durch mechanischen Materialabtrag, etwa Fräsen oder Aufbohren, vergrößert; es verbleibt zunächst ein Vor-Innenelement 23a mit reduzierter Wandstärke und vergrößertem Hohlraum 24a. Sodann wird das verbliebene Vor-Innenelement 23a hier vollständig chemisch abgetragen, etwa Abätzen, beispielsweise durch Salpetersäure im Falle eines Vor-Innenelements 23 aus Bronze. In der gezeigten Variante besteht der danach verbleibende Außenmantel 20a also nur noch aus dem Vor-Cu-Stabilisierungshüllrohr 21 und der Vor-Diffusionsbarriere 22, mit einem Hohlraum 25, der sich innenseitig an die Vor-Diffusionsbarriere 22 anschließt. Man beachte, dass die Hohlräume 24, 24a, 25 sich über eine erhebliche Länge des Außenmantels 20, 20a erstrecken (in Fig. 5 senkrecht zur Zeichenebene), und der Materialabtrag über diese gesamten Länge erfolgt.

Alternativ kann auch ein Rest des Vor-Innenelements 23 bzw. 23a im Außenmantel 20a verbleiben, um insbesondere nach einem mechanischen Materialabtrag die Unversehrtheit bzw. eine überall ausreichende Dicke der Vor-Diffusionsbarriere 22 mit höherer Sicherheit zu gewährleisten.

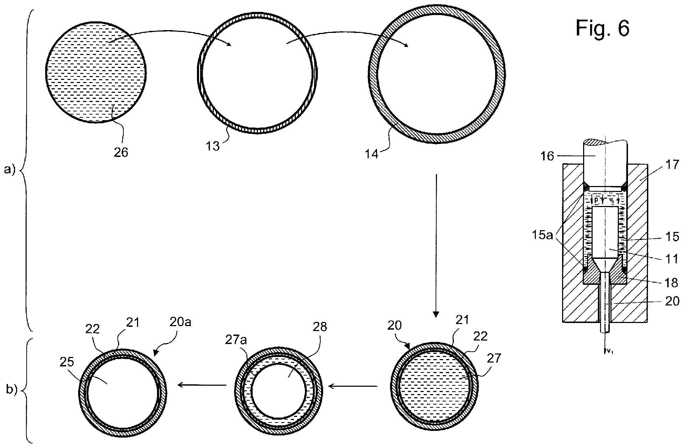

In der **Fig. 6** wird eine zweite Variante für einen ersten Teil eines erfindungsgemäßen Verfahrens zur Herstellung eines erfindungsgemäßen Halbzeugdrahtes, etwa eines Halbzeugdrahtes gemäß Fig. 2, vorgestellt. Die zweite Variante ist der ersten Variante von Fig. 5 ähnlich, so dass nur die wesentlichen Unterschiede vorgestellt werden.

In der in Fig. 6 vorgestellte Variante wird in Schritt a) für den Block 11 ein Vollzylinder 26 aus einem Material für ein Vor-Innenelement eingesetzt, der in das Rohr 13 aus einem Material für eine Vor-Diffusionsbarriere eingesteckt wird. In das Rohr 14 aus einem Material für ein Vor-Cu-Stabilisierungshüllrohr wird das Rohr 13 mitsamt dem Vollzylinder 26 eingesteckt.

Im durch das Extrudieren des Blocks 11 erhaltenen Außenmantel 20 ist dann in der Vor-Diffusionsbarriere 22 ein vollzylindrisches Vor-Innenelement 27 enthalten. In das Vor-Innenelement 27 wird dann durch mechanischen Materialabtrag, insbesondere Bohren, ein Hohlraum 28 eingebracht. Anschließend wird das verbliebene Vor-Innenelement 27 hier wiederum vollständig chemisch abgetragen, etwa durch Abätzen.

Es wird wiederum ein verbleibender Außenmantel 20a bestehend aus dem Vor-Cu-Stabilisierungshüllrohr 21 und der Vor-Diffusionsbarriere 22 erhalten, mit einem Hohlraum 25, der sich innenseitig an die Vor-Diffusionsbarriere 22 anschließt.

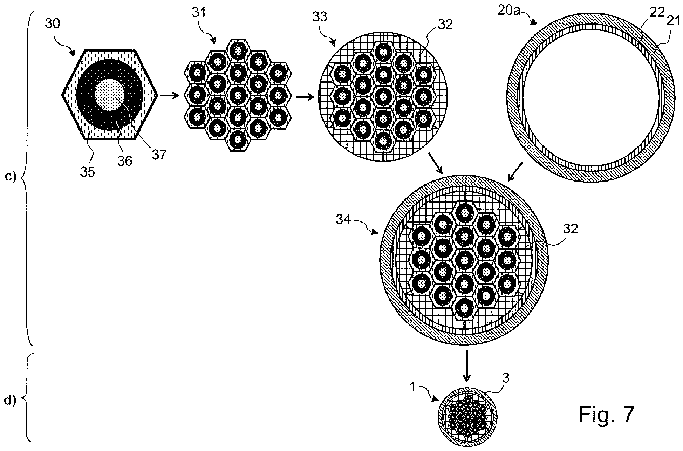

Die **Fig. 7** illustriert schematisch den weiteren Fortschritt der Fertigung eines erfindungsgemäßen Halbzeugdrahts, etwa anschließend an die Schritte a) und b) gemäß Fig. 5 oder Fig. 6. In der Figur werden Querschnitte gezeigt.

In einem dritten Schritt c) werden eine Vielzahl von Vor-PIT-Elementen 30 in einem Bündel 31 angeordnet und mit Vor-Füllelementen 32 umbaut. Dieses Ensemble 33 wird im (nach dem hier vollständigen Abtrag des Vor-Innenelements) verbliebenen Außenmantel 20a, und damit innerhalb der Vor-Diffusionsbarriere 22, angeordnet. Dadurch wird ein Vor-Halbzeugdraht 34 erhalten. Zwischen dem verbliebenen Außenmantel 20a und den Vor-Füllelementen 32, und insgesamt im Vor-Halbzeugdraht 34, verbleiben keine merklichen Hohlräume.

In einem Schritt d wird nun der Vor-Halbzeugdraht einer querschnittsreduzierenden Umformung unterzogen, etwa einem Strangpressen, Ziehen oder Drahtwalzen. Man beachte, dass die Umformung auch mehrstufig und in Abfolgen verschiedener Umformungstechniken erfolgen kann. Nach der Umformung wird ein erfindungsgemäßer Halbzeugdraht 1 erhalten, welcher einen gegenüber dem Vor-Halbzeugdraht 34 verminderten Außendurchmesser aufweist. Im Halbzeugdraht 1 ist nach der Querschnittsreduktion keine merkliche Welligkeit in der Diffusionsbarriere 3 entstanden.

Im Rahmen der vorliegenden Erfindung wird nach dem Strangpressen von Schritt a) bis einschließlich der querschnittsreduzierenden Umformung von Schritt d) und einschließlich einem etwaigen Verseilen zu einem Halbzeugkabel und Positionieren des Halbzeugdrahts oder Halbzeugkabels im Allgemeinen keine Zwischenglühung durchgeführt, wodurch die Herstellung einfach gehalten wird. Bei bestimmten Halbzeugdrahtdesigns, insbesondere ohne elementarem Sn in den Pulverkernen der PIT-Elemente, können jedoch auch im Rahmen der Erfindung eine oder mehrere Zwischenglühungen vorteilhalft angewandt werden.

Man beachte, dass die Vor-PIT-Elemente 30, die Vor-Füllelemente 32, das Vor-Cu-Stabilisierungshüllrohr 21 und die Vor-Diffusionsbarriere 22 im Wesentlichen den PIT-Elementen 6, den Füllelementen 5, dem Cu-Stabilisierungshüllrohr 2 und der Diffusionsbarriere 3 im Halbzeugdraht 1 entsprechen, jedoch noch größere Abmessungen aufweisen, da die querschnittsreduzierende Umformung noch nicht erfolgt ist. Insbesondere weist ein Vor-PIT-Element 30 eine Cu-haltige Vor-Umhüllung 35, ein Vor-Röhrchen 36 aus Nb oder einer Nb-Legierung und einen Vor-Pulverkern 37 auf.

Wie aus **Fig. 8** ersichtlich, können mehrere Halbzeugdrähte 1 zu einem Halbzeugkabel 40, hier ausgebildet als Flachkabel, verseilt (verdrillt) werden. Man beachte, dass neben Flachkabeln mit rechteckigem Querschnitt auch Flachkabel mit keilförmigem Querschnitt gefertigt werden können. Typische Flachkabel für die Erfindung weisen im Querschnitt ein Aspektverhältnis von 4 oder größer auf. In Flachkabeln treten starke Deformationen der Halbzeugdrähte 1 an den kurzen Kabelkanten auf, die gut von einem erfindungsgemäßen Halbzeugdraht 1 toleriert werden können. Flachkabel werden typischerweise zu Windungen in Form einer Rennbahnspule (Race-Track-Coil) für Magnetwicklungen weiterverarbeitet (nicht näher dargestellt). Zudem können auch nicht-flache Kabel 40, etwa im Querschnitt runde Kabel, aus mehreren Halbzeugdrähten 1 gefertigt werden (nicht näher dargestellt).

Ein Halbzeugdraht 1 oder ein Halbzeugkabel 40 kann insbesondere nach Art einer Solenoidspule auf einem zylindrischen Spulenträger 50 aufgewickelt werden, und in einem Glühofen 51 einem Reaktionsglühen unterzogen werden, vgl. **Fig. 9****.** Ebenso können beispielsweise auch Rennbahnspulen im Glühofen 51 einem Reaktionsglühen unterzogen werden (nicht näher dargestellt). Während des Reaktionsglühens (typischerweise bei 600-700°C für einige Tage bis einige Wochen) wird in den PIT-Elementen der verbauten Halbzeugdrähte die supraleitende A15-Phase gebildet, insbesondere Nb3Sn, wobei eine Kontamination der Cu-Stabilisierungshüllrohre durch die Diffusionsbarrieren ausgeschlossen ist. Die Diffusionsbarrieren benötigen dabei nur einen sehr geringen Flächenanteil, so dass umgekehrt im jeweiligen aus einem Halbzeugdraht erhaltenen Supraleiterdraht ein großer Flächenanteil für die A15-Phase zur Verfügung steht; zudem kann viel Sn im Halbzeugdraht bevorratet werden, so dass ein sehr großer Anteil des in den PIT-Elementen vorhandenen Nb, insbesondere im Bereich der bisherigen Röhrchen, zur A15-Phase umgesetzt werden kann. Entsprechend können sehr hohe Stromtragfähigkeiten der fertigen Nb3Sn-haltigen Supraleiterdrähte bzw. des fertigen Nb3Sn-haltigen Supraleiterkabels erreicht werden.

### Experimentelle Daten

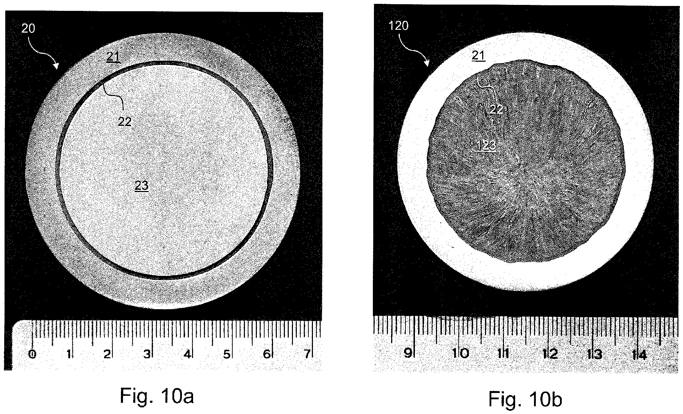

Das erfindungsgemäße Vorgehen bei der Herstellung eines Außenmantels für einen erfindungsgemäßen Halbzeugdraht, vgl. hierzu insbesondere Schritt a) des erfindungsgemäßen Herstellungsverfahrens, durch Strangpressen wurde anhand eines Fertigungsbeispiels mit einem Vor-Innenelement aus einem Vollzylinder beispielhaft erprobt, vgl. hierzu auch Fig. 6 oben. Zum Vergleich wurde weiterhin ein Außenmantel für einen Halbzeugdraht herkömmlich durch Strangpressen hergestellt. Die erhaltenen Außenmäntel wurden im Querschliff präpariert. Die **Fig. 10a** zeigt einen gemäß der Erfindung hergestellten Außenmantel 20 in einer lichtoptischen Aufnahme (einschließlich eines cm-Maßstabs), und die **Fig. 10b** zeigt den herkömmlich hergestellten Außenmantel 120 in einer lichtoptischen Aufnahme (einschließlich eines cm-Maßstabs).

**Tabelle 1: erfindungsgemäß hergestellter Außenmantel (Fig. 10a):**

| *Struktur* | *Werkstoff* | *Flächenanteil* | *Mittlere Korngröße kalt vor Strangpressen* | *Mittlere Korngröße warm vor Strangpressen* | *Mittlere Korngröße nach Strangpressen* |
|---|---|---|---|---|---|
| Cu-Stabilisierungshüllrohr 21 | Cu OFE | 25 % | 200 µm | 300 µm | 200 µm |
| Diffusionsbarriere 22 | Nb | 6 % | 60 µm | 60 µm | < 60 µm * |
| Vor-Innenelement 23 | CuSnTi | 69% | 20 µm | 20 µm | 20 µm |

| | | | | | |
|---|---|---|---|---|---|
| *: Subkorngröße, Gefüge nicht rekristallisiert | | | | | |

Für den im Rahmen der Erfindung gefertigten Außenmantel 20 wurde eine CuSnTi-Legierung für das Vor-Innenelement 23 eingesetzt, welches eine mittlere Korngröße MKI warm (unmittelbar vor dem Strangpressen) von hier 20 µm aufwies. Das Niob für die Vor-Diffusionsbarriere 22 hatte warm (unmittelbar vor dem Strangpressen) eine mittlere Korngröße MKD von 60 µm. Das Cu OFE für das Vor-Cu-Stabilisierungshüllrohr 21 hatte warm (unmittelbar vor dem Strangpressen) eine mittlere Korngröße MKS von 300 µm.

Für den herkömmlich gefertigten Außenmantel 120 wurde wiederum Cu OFE für das Vor-Cu-Stabilisierungshüllrohr 21 und Nb für die Vor-Diffusionsbarriere 22 verwendet (siehe oben); für das Vor-Innenelement 123 wurde jedoch ein Guss-Kupfer verwendet.,

Nach dem Strangpressen des Außenmantels 20 mit dem Vor-Innenelement 23 aus der CuSnTi-Legierung wurde eine sehr glatte Wand der Diffusionsbarriere 22 ohne merkliche Welligkeit bei einer Dicke von ca. 1,5 mm erhalten (Fig. 10a).

Hingegen weist die Vor-Diffusionsbarriere 22 bei dem mit dem Vor-Innenelement 123 aus Guss-Kupfer gefertigten Außenmantel 120 eine erhebliche Welligkeit auf (Fig. 10b). Der Außenradius der Vor-Diffusionsbarriere 22 variiert hier um ca. 0,5 mm, bei einer Dicke der Vor-Diffusionsbarriere 22 von ebenfalls ca. 1,5 mm. Diese erhebliche Welligkeit kann bei nachfolgenden querschnittsreduzierenden Umformungen zu Lücken in der Diffusionsbarriere führen. Die Umrisse der Körner im Guss-Gefüge des Vor-Innenelements 123 sind in Fig. 10b durch Ätzen sichtbar gemacht worden. Auf Grund der Größe der Umrisse der Körner nach dem Strangpressen im mm bis cm Maßstab, kann geschlossen werden, dass die Körner vor dem Strangpressen mindestens ebenso im mm bis cm Maßstab vorgelegen haben sollten.

## Patentansprüche

1. Halbzeugdraht (1) für einen Nb3Sn-haltigen Supraleiterdraht, umfassend:
- ein Cu-Stabilisierungshüllrohr (2),
- eine ringförmig geschlossene Diffusionsbarriere (3) im Inneren des Cu-Stabilisierungshüllrohrs (2),
- eine Vielzahl von PIT-Elementen (6) im Inneren der Diffusionsbarriere (3), jeweils umfassend
∘ eine Cu-haltige Umhüllung (8),
∘ ein Röhrchen (9), und
∘ einen Sn-haltigen Pulverkern (10),
**dadurch gekennzeichnet,**
**dass** das Röhrchen (9) aus Nb oder einer Nb-haltigen Legierung besteht, dass die Diffusionsbarriere (3) im Querschnitt des Halbzeugdrahts (1) einen Flächenanteil ADF aufweist mit 3 % ≤ ADF ≤ 9 % und weiterhin eine Wandstärke WDF aufweist mit 8 µm ≤ WDF ≤ 25 µm, und
**dass** im Inneren der Diffusionsbarriere (3) weiterhin mehrere Füllelemente (5) angeordnet sind, die innenseitig an den PIT-Elementen (6) anliegen.

2. Halbzeugdraht (1) nach Anspruch 1, **dadurch gekennzeichnet, dass** die Füllelemente (5) außenseitig unmittelbar an der Diffusionsbarriere (3) anliegen.

3. Halbzeugdraht (1) nach einem der vorhergehenden Ansprüche, **dadurch gekennzeichnet, dass** die PIT-Elemente (6) einen hexagonalen Querschnitt aufweisen.

4. Halbzeugdraht (1) nach einem der vorhergehenden Ansprüche, **dadurch gekennzeichnet, dass** die Röhrchen (9) aus Nb oder der Nb-haltigen Legierung in den PIT-Elementen (6) einen runden Querschnitt aufweisen.

5. Halbzeugdraht (1) nach einem der vorhergehenden Ansprüche, **dadurch gekennzeichnet, dass** für den Flächenanteil ADF der Diffusionsbarriere (3) gilt 4 % ≤ ADF ≤ 8 %.

6. Halbzeugdraht (1) nach einem der vorhergehenden Ansprüche, **dadurch gekennzeichnet, dass** das Cu-Stabilisierungshüllrohr (2) im Querschnitt des Halbzeugdrahts (1) einen Flächenanteil ASH aufweist mit 12 % ≤ ASH ≤ 30 %, bevorzugt 18 % ≤ ASH ≤ 30 %, besonders bevorzugt 22 % ≤ ASH ≤ 27 %.

7. Halbzeugdraht (1) nach einem der vorhergehenden Ansprüche, **dadurch gekennzeichnet, dass** das Cu-Stabilisierungshüllrohr (2) einen Außendurchmesser DSH aufweist mit 0,5 mm ≤ DSH ≤ 1,2 mm, bevorzugt 0,6 mm ≤ DSH ≤ 0,9 mm.

8. Halbzeugdraht (1) nach einem der vorhergehenden Ansprüche, **dadurch gekennzeichnet, dass** die Röhrchen (9) aus Nb oder einer Nb-haltigen Legierung einen Durchmesser DRö aufweisen mit 20 µm ≤ DRö ≤ 55 µm, bevorzugt 20 µm ≤ DRö ≤ 45 µm.

9. Halbzeugdraht (1) nach einem der vorhergehenden Ansprüche, **dadurch gekennzeichnet, dass** in den Sn-haltigen Pulverkernen (10) ein Gesamt-Sn-Anteil GSn von wenigstens 80 Massen-% enthalten ist, insbesondere wobei 85 Massen-% ≤ GSn ≤ 90 Massen-%.

10. Halbzeugdraht (1) nach einem der vorhergehenden Ansprüche, **dadurch gekennzeichnet, dass** die Diffusionsbarriere (3) wenigstens 50 Massen-% Nb oder wenigstens 50 Massen-% Ta enthält.

11. Halbzeugkabel (40) für ein Nb3Sn-haltiges Supraleiterkabel, umfassend mehrere verseilte Halbzeugdrähte (1) nach einem der Ansprüche 1 bis 10, insbesondere wobei das Halbzeugkabel (40) als ein Flachkabel ausgebildet ist.

12. Nb3Sn-haltiger Supraleiterdraht oder Nb3Sn-haltiges Supraleiterkabel, hergestellt durch Reaktionsglühen eines Halbzeugdrahts (1) nach einem der Ansprüche 1 bis 10 oder eines Halbzeugkabels (40) nach Anspruch 11.

13. Nb3Sn-haltiger Supraleiterdraht oder Nb3Sn-haltiges Supraleiterkabel nach Anspruch 12, **dadurch gekennzeichnet, dass** beim Reaktionsglühen das in den Röhrchen (9) enthaltene Nb zu wenigstens 80 % zu einer A15-Phase reagiert worden ist.

14. Nb3Sn-haltiger Supraleiterdraht oder Nb3Sn-haltiges Supraleiterkabel nach einem der Ansprüche 12 oder 13, **dadurch gekennzeichnet, dass** der Nb3Sn-haltige Supraleiterdraht oder das Nb3Sn-haltige Supraleiterkabel ein Restwiderstandsverhältnis RRR von wenigstens 100, bevorzugt wenigstens 150 aufweist.

15. Verfahren zur Herstellung eines Halbzeugdrahts (1) nach einem der Ansprüche 1 bis 10, mit folgenden Schritten:
a) ein Außenmantel (20) wird durch Strangpressen, insbesondere hydrostatisches Strangpressen, gefertigt, wobei der Außenmantel (20) ein Vor-Cu-Stabilisierungshüllrohr (21), eine Vor-Diffusionsbarriere (22) innerhalb des Vor-Cu-Stabilisierungshüllrohrs (21) und ein Vor-Innenelement (23) innerhalb der Vor-Diffusionsbarriere (22) umfasst, wobei das Material für das Vor-Innenelement (23) so gewählt ist, dass unmittelbar vor der plastischen Verformung durch das Strangpressen eine mittlere Korngröße MKI des Materials für das Vor-Innenelement (23) maximal 3-mal so groß ist wie eine mittlere Korngröße MKD des Materials für die Vor-Diffusionsbarriere (22),
b) zumindest ein Teil des Vor-Innenelements (23) wird über die Länge des Außenmantels aus dem Außenmantel (20) entfernt,
c) eine Vielzahl von Vor-PIT-Elementen (30) wird zusammen mit mehreren Vor-Füllelementen (32) innerhalb der Vor-Diffusionsbarriere (22) angeordnet, wobei die Vor-Füllelemente (32) an einer Innenseite des verbliebenen Außenmantels (20a) und an den Vor-PIT-Elementen (30) anliegen,
d) der so erhaltene Vor-Halbzeugdraht (34) wird einer querschnittsreduzierenden Umformung unterzogen, wodurch der Halbzeugdraht (1) erhalten wird.

16. Verfahren nach Anspruch 15, **dadurch gekennzeichnet, dass** das Material für das Vor-Cu-Stabilisierungshüllrohr (21) unmittelbar vor der plastischen Verformung durch das Strangpressen eine mittlere Korngröße MKS aufweist, wobei gilt MKS ≥ 2·MKI, bevorzugt MKS ≥ 5·MKI.

17. Verfahren nach einem der Ansprüche 15 oder 16, **dadurch**
**gekennzeichnet, dass** unmittelbar vor dem Strangpressen die Materialien für den Außenmantel (20) auf eine Temperatur TSP ≥ 450°C aufgeheizt sind.

18. Verfahren nach einem der Ansprüche 15 bis 17, **dadurch**
**gekennzeichnet, dass** als Vor-Innenelement (23) in Schritt a) ein Hohlzylinder ausgebildet wird.

19. Verfahren nach einem der Ansprüche 15 bis 18, **dadurch**
**gekennzeichnet, dass** in Schritt b) das Vor-Innenelement (23) vollständig aus dem Außenmantel (20) entfernt wird.

20. Verfahren nach einem der Ansprüche 15 bis 19, **dadurch**
**gekennzeichnet, dass** das Material für das Vor-Innenelement (23) als eine Cu-Sn-, Cu-Ni-, Cu-Zn- oder eine Cu-Al-haltige Legierung gewählt ist.

## Claims

1. Semifinished wire (1) for a superconducting wire containing Nb3Sn, comprising
- a Cu stabilization cladding tube (2),
- a ring-shaped closed diffusion barrier (3) in the inside of the Cu stabilization cladding tube (2),
- a plurality of PIT elements (6) in the inside of the diffusion barrier (3), each comprising
- a cladding (8) containing Cu,
- a small tube (9), and
- a powder core (10) containing Sn,
**characterized in that** the small tube (9) consists of Nb or an alloy containing Nb, that the diffusion barrier (3) has a percentage of area ADF in cross-section of the semifinished wire (1) of 3% ≤ ADF 9% and moreover has a wall thickness WDF with 8µm ≤ WDF ≤ 25µm, and that moreover a plurality of filler elements (5) are arranged in the inside of the diffusion barrier (3), wherein the inner sides of the filler elements (5) abut the PIT elements (6).

2. Semifinished wire (1) according to claim 1, **characterized in that** the outer sides of the filler elements (5) directly abut the diffusion barrier (3).

3. Semifinished wire (1) according to any one of the preceding claims, **characterized in that** the PIT elements (6) have a hexagonal cross-section.

4. Semifinished wire (1) according to any one of the preceding claims, **characterized in that** the small tubes (9) of Nb or the alloy containing Nb in the PIT elements (6) have a round cross-section.

5. Semifinished wire (1) according to any one of the preceding claims, **characterized in that** the following applies to the percentage of area ADF of the diffusion barrier (3): 4% ≤ ADF ≤ 8%.

6. Semifinished wire (1) according to any one of the preceding claims, **characterized in that** the Cu stabilization cladding tube (2) has a percentage of area ASH in cross-section of the semifinished wire (1) of 12% ≤ ASH ≤ 30%, preferably 18% ≤ ASH ≤ 30%, preferentially 22% ≤ ASH ≤ 27%.

7. Semifinished wire (1) according to any one of the preceding claims, **characterized in that** the Cu stabilization cladding tube (2) has an outer diameter DSH of 0.5 mm ≤ DSH ≤ 1.2 mm, preferably 0.6 mm ≤ DSH ≤ 0.9 mm.

8. Semifinished wire (1) according to any one of the preceding claims, **characterized in that** the small tubes (9) of Nb or an alloy containing Nb have a diameter DRö with 20 µm ≤ DRö ≤ 55 µm, preferably 20 µm ≤ DRö ≤ 45 µm.

9. Semifinished wire (1) according to any one of the preceding claims, **characterized in that** the Sn-containing powder cores (10) contain an overall Sn portion GSn of at least 80 mass %, in particular, wherein 85 mass % ≤ GSn ≤ 90 mass %.

10. Semifinished wire (1) according to any one of the preceding claims, **characterized in that** the diffusion barrier (3) contains at least 50 mass % of Nb or at least 50 mass % of Ta.

11. Semifinished cable (40) for a superconducting cable containing Nb3Sn, comprising a plurality of stranded semifinished wires (1) according to any one of the claims 1 through 10, in particular wherein the semifinished cable (40) is designed as a flat cable.

12. Superconducting wire containing Nb3Sn or superconducting cable containing Nb3Sn, produced through reaction annealing of a semifinished wire (1) according to any one of the claims 1 through 10 or of a semifinished cable (40) according to claim 11.

13. Superconducting wire containing Nb3Sn or superconducting cable containing Nb3Sn according to claim 12, **characterized in that** at least 80% of the Nb contained in the small tubes (9) has been reacted to an A15 phase during reaction annealing.

14. Superconducting wire containing Nb3Sn or superconducting cable containing Nb3Sn according to any one of the claims 12 or 13, **characterized in that** the superconducting wire containing Nb3Sn or the superconducting cable containing Nb3Sn has a residual resistance ratio RRR of at least 100, preferably at least 150.

15. Method for the production of a semifinished wire (1) according to any one of the claims 1 through 10, comprising the following steps:
a) an outer jacket (20) is produced through extrusion, in particular hydrostatic extrusion, wherein the outer jacket (20) comprises a pre-Cu stabilization cladding tube (21), a pre-diffusion barrier (22) within the pre-Cu stabilization cladding tube (21) and a pre-inner element (23) within the pre-diffusion barrier (22), wherein the material for the pre-inner element (23) is selected such that directly prior to plastic deformation through extrusion an average particle size MKI of the material for the pre-inner element (23) is maximally 3 times as large as an average particle size MKD of the material for the pre-diffusion barrier (22),
b) at least part of the pre-inner element (23) is removed from the outer jacket (20) along the length of the outer jacket,
c) a plurality of pre-PIT elements (30) is arranged together with a plurality of pre-filler elements (32) within the pre-diffusion barrier (22), wherein the pre-filler elements (32) abut an inner side of the remaining outer jacket (20a) and abut the pre-PIT elements (30),
d) the pre-semifinished wire (34) obtained in this fashion is subjected to cross-section-reducing shaping, thereby obtaining the semifinished wire (1).

16. Method according to claim 15, **characterized in that** the material for the pre-Cu stabilization cladding tube (21) has an average particle size MKS directly prior to plastic deformation by extrusion, wherein MKS ≥ 2·MKI, preferably MKS ≥ 5·MKI.

17. Method according to any one of the claims 15 or 16, **characterized in that** directly prior to extrusion the materials for the outer jacket (20) are heated to a temperature TSP ≥ 450°C.

18. Method according to any one of the claims 15 through 17, **characterized in that** a hollow cylinder is formed as pre-inner element (23) in step a).

19. Method according to any one of the claims 15 through 18, **characterized in that** the pre-inner element (23) is completely removed from the outer jacket (20) in step b).

20. Method according to any one of the claims 15 through 19, **characterized in that** the material for the pre-inner element (23) is selected as an alloy containing Cu-Sn, Cu-Ni, Cu-Zn or Cu-Al.

## Revendications

1. Fil semi-fini (1) pour un fil supraconducteur contenant Nb3Sn, comprenant :
- un tube enveloppe de stabilisation en Cu (2),
- une barrière de diffusion (3) annulaire fermée à l'intérieur du tube enveloppe de stabilisation en Cu (2),
- une pluralité d'éléments PIT (6) à l'intérieur de la barrière de diffusion (3), comprenant chacun
o une enveloppe (8) contenant Cu,
o un petit tube (9) et
o un noyau en poudre (10) contenant Sn,
**caractérisé en ce**
**que** le petit tube (9) est constitué de Nb ou d'un alliage contenant Nb,
**que** la barrière de diffusion (3) présente, en section transversale du fil semi-fini (1), une proportion de surface ADF avec 3 % ≤ ADF ≤ 9 % ainsi qu'une épaisseur de paroi WDF avec 8 µm ≤ WDF ≤ 25 µm, et
**qu'**à l'intérieur de la barrière de diffusion (3) sont disposés d'autres éléments de remplissage (5) qui sont intérieurement en contact avec les éléments PIT (6).

2. Fil semi-fini (1) selon la revendication 1, **caractérisé en ce que** les éléments de remplissage (5) sont extérieurement directement en contact avec la barrière de diffusion (3).

3. Fil semi-fini (1) selon l'une des revendications précédentes, **caractérisé en ce que** les éléments PIT (6) présentent une section transversale hexagonale.

4. Fil semi-fini (1) selon l'une des revendications précédentes, **caractérisé en ce que** les tubes (9) en Nb ou en alliage contenant Nb dans les éléments PIT (6) présentent une section transversale ronde.

5. Fil semi-fini (1) selon l'une des revendications précédentes, **caractérisé en ce qu'**il s'applique pour la proportion de surface ADF de la barrière de diffusion (3) 4 % ≤ ADF ≤ 8 %.

6. Fil semi-fini (1) selon l'une des revendications précédentes, **caractérisé en ce que** le tube enveloppe de stabilisation en Cu (2) présente en section transversale du fil semi-fini (1) une proportion de surface ASH avec 12 % ≤ ASH ≤ 30 %, de préférence 18 % ≤ ASH ≤ 30 %, particulièrement de préférence 22 % ≤ ASH ≤ 27 %.

7. Fil semi-fini (1) selon l'une des revendications précédentes, **caractérisé en ce que** le tube enveloppe de stabilisation en Cu (2) présente un diamètre extérieur DSH avec 0,5 mm ≤ DSH ≤ 1,2 mm, de préférence 0,6 mm ≤ DSH ≤ 0,9 mm.

8. Fil semi-fini (1) selon l'une des revendications précédentes, **caractérisé en ce que** les petits tubes (9) en Nb ou en alliage contenant Nb présentent un diamètre DRö avec 20 µm ≤ DRö ≤ 55 µm, de préférence 20 µm ≤ DRö ≤ 45 µm.

9. Fil semi-fini (1) selon l'une des revendications précédentes, **caractérisé en ce que** les noyaux en poudre (10) contenant Sn contiennent une proportion totale de Sn GSn d'au moins 80 % en masse, en particulier telle que 85 % en masse ≤ GSn ≤ 90 % en masse.

10. Fil semi-fini (1) selon l'une des revendications précédentes, **caractérisé en ce que** la barrière de diffusion (3) contient au moins 50 % en masse de Nb ou au moins 50 % en masse de Ta.

11. Câble semi-fini (40) pour un câble supraconducteur contenant Nb3Sn, comprenant plusieurs fils semi-finis (1) selon l'une des revendications 1 à 10 toronnés, en particulier le câble semi-fini (40) étant réalisé sous la forme d'un câble plat.

12. Fil supraconducteur contenant Nb3Sn ou câble supraconducteur contenant Nb3Sn, fabriqué par recuit réactionnel d'un fil semi-fini (1) selon l'une des revendications 1 à 10 ou d'un câble semi-fini (40) selon la revendication 11.

13. Fil supraconducteur contenant Nb3Sn ou câble supraconducteur contenant Nb3Sn selon la revendication 12, **caractérisé en ce que**, lors du recuit réactionnel, le Nb contenu dans les petits tubes (9) a été transformé à au moins 80 % en une phase A15.

14. Fil supraconducteur contenant Nb3Sn ou câble supraconducteur contenant Nb3Sn selon l'une des revendications 12 ou 13, **caractérisé en ce que** le fil supraconducteur contenant Nb3Sn ou le câble supraconducteur contenant Nb3Sn présente un rapport de résistivité résiduelle RRR inférieur à 100, de préférence inférieur à 150.

15. Procédé de fabrication d'un fil semi-fini (1) selon l'une des revendications 1 à 10, présentant les étapes suivantes :
a) une enveloppe extérieure (20) est réalisée par extrusion, en particulier par extrusion hydrostatique, l'enveloppe extérieure (20) comprenant un pré-tube enveloppe de stabilisation en Cu (21), une pré-barrière de diffusion (22) à l'intérieur du pré-tube enveloppe de stabilisation en Cu (21) et un pré-élément intérieur (23) à l'intérieur de la pré-barrière de diffusion (22), le matériau pour le pré-élément intérieur (23) étant choisi de façon qu'immédiatement avant la déformation plastique par l'extrusion, une granulométrie moyenne MKI du matériau pour le pré-élément intérieur (23) soit au maximum 3 fois plus grande qu'une granulométrie moyenne MKD du matériau pour la pré-barrière de diffusion (22),
b) au moins une partie du pré-élément intérieur (23) est éliminée de l'enveloppe extérieure (20) sur la longueur de l'enveloppe extérieure,
c) une pluralité de pré-éléments PIT (30) est disposée avec plusieurs pré-éléments de remplissage (32) à l'intérieur de la pré-barrière de diffusion (22), les pré-éléments de remplissage (32) étant en contact avec un côté intérieur de l'enveloppe extérieure (20a) restante et avec les pré-éléments PIT (30),
d) le pré-fil semi-fini (34) ainsi obtenu est soumis à une déformation réduisant la section transversale, moyennant quoi le fil semi-fini (1) est obtenu.

16. Procédé selon la revendication 15, **caractérisé en ce que** le matériau pour le pré-tube enveloppe de stabilisation en Cu (21) immédiatement avant la déformation plastique par l'extrusion présente une granulométrie moyenne MKS, avec MKS ≥ 2·MKI, de préférence MKS ≥ 5·MKI.

17. Procédé selon l'une des revendications 15 ou 16, **caractérisé en ce qu'**immédiatement avant l'extrusion, les matériaux pour l'enveloppe extérieure (20) sont chauffés à une température TSP ≥ 450 °C.

18. Procédé selon l'une des revendications 15 à 17, **caractérisé en ce qu'**à l'étape a), un cylindre creux est réalisé en tant que pré-élément intérieur (23).

19. Procédé selon l'une des revendications 15 à 18, **caractérisé en ce qu'**à l'étape b), le pré-élément intérieur (23) est complètement éliminé de l'enveloppe extérieure (20).

20. Procédé selon l'une des revendications 15 à 19, **caractérisé en ce que** le matériau pour le pré-élément intérieur (23) est choisi parmi des alliages contenant Cu-Sn, Cu-Ni, Cu-Zn ou Cu-Al.
